# EUROPEAN PATENT APPLICATION

(11) **EP 0 661 739 A2**
(43) Date of publication of application: **05.07.1995**
(21) Application number: 94120819.1
(22) Date of filing: 28.12.1994
(51) Int. Cl.: H01L 23/433

(54) **Pin-grid array with a cooling structure**

(30) Priority: 29.12.1993 JP 352435/93
(71) Applicant: NEC CORPORATION, Tokyo (JP)
(72) Inventor: Kudo, Kiyofumi, Minato-ku, Tokyo (JP)
(74) Representative: VOSSIUS & PARTNER

(57) **Abstract**

A pin-grid array with a cooling structure includes a substrate. A cavity is provided in the upper surface of the substrate. An electrical device (3) (e.g., a large-scale integrated circuit) is placed in the cavity of the substrate (1) and leads (4) connect the substrate (1) and the LSI (3). A cap (6) covers the cavity and a heat sink (7) is attached to the cap (6). A heat conductive material (5) is filled between the LSI (3) and the cap (6). The material (5) conducts the heat generated by the LSI (3) to the cap (6), and then to the heat sink (7). Pins (16) are arranged across substantially the entire lower surface of the substrate (1). A bent portion of the cap (6) protrudes toward the LSI (3). The bent portion narrows the gap between the cap (6) and the LSI (3). An insulating film (4a) is provided between the leads (4) and the cap (6) for preventing a short-circuit.

## Description

The present invention relates to a pin-grid array, and more particularly to a pin-grid array with a structure for cooling an electrical device such as a large-scale integrated circuit (LSI) mounted therein.

A pin-grid array is a package having electrical terminals arranged in a prescribed matrix format or array. A technical advantage of the pin-grid array is its ability to accommodate many electronic terminals. However, the number of electronic terminals may be reduced when a cooling structure such as a heat sink is attached to the pin-grid array. A cooling structure is indispensable to the pin-grid array when a high-power electrical circuit such as an LSI, which generates heat of the order of 5W or more, is mounted therein. There are several conventional systems in which the number of pins is reduced by providing a heat sink.

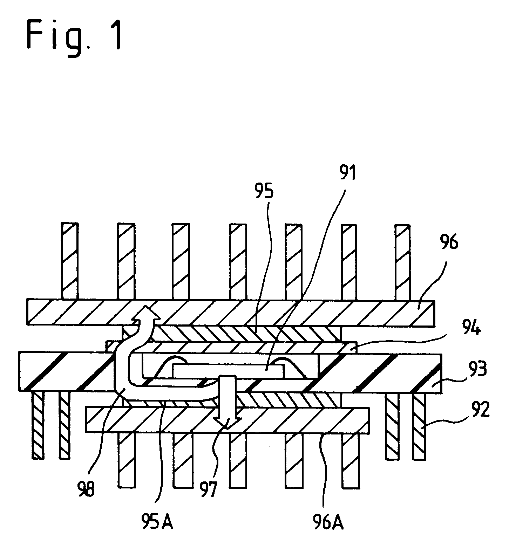

Referring to fig. 1 showing the pin-grid array of an aforementioned conventional system, a cooling fin 96A is attached to the lower surface of a substrate 93. External pins 92 are arranged on the lower surface. The heat generated from an LSI 91 is conducted to and removed from the cooling fin 96A via a route 97 traversing through the substrate 93. The heat is also removed from the cooling fin 96A via another route 98 which is a detour avoiding a cavity in the substrate receiving the LSI 91.

In this pin-grid array, pins 92 can only be arranged in the marginal area of the lower surface of the substrate 93 because the cooling fin 96A occupies the central area thereof. Thus, the number of pins is reduced in this conventional pin-grid array and thus the cooling efficiency of the structure is severely degraded.

If the cooling fin 96A is removed, the central area of the substrate 93 can accommodate more pins 92. However, this configuration decreases the heat radiating efficiency of the pin-grid array because the heat resistance of the route 98 is higher than that of the route 97 and the route 97 alone cannot conduct therethrough all of the heat generated from the LSI 91.

As stated above, the decreased number of electronic terminals cannot be avoided when a cooling structure is attached to this kind of pin-grid array. Therefore, the pin-grid array becomes larger to maintain the same number of pins which in turn increases the size of the entire electronic component packaging.

Therefore, an object of the present invention is to provide a pin-grid array for efficiently removing heat from an electrical device (e.g., LSI).

Another object of the present invention is to provide a pin-grid array which does not become larger even when a cooling structure is provided to remove the heat generated from the LSI.

According to the present invention, a pin-grid array comprises a substrate. The substrate has a plurality of electrical terminals on its lower surface. A cavity is provided in the upper surface of the substrate. An LSI is placed in the cavity of the substrate. A conductor electrically connects the substrate and the LSI. In the first and second embodiments of the invention, the conductor includes tape automated bonding (TAB) leads. In the third and fourth embodiments, the conductor includes gold wires. The LSI is electrically connected to the electrical terminals of the substrate via the conductor. A cap covers the cavity of the substrate. A heat conductive material is positioned between the LSI and the cap.

Among the aforementioned structure, the heat conductive material is one feature of the invention. The material conducts the heat generated from the LSI to the cap, and then subsequently to the cooling structure attached on the cap. Therefore, it is unnecessary to provide a cooling structure on the lower surface of the substrate where electrical terminals are arranged. Thus, electrical terminals can be arranged across the entire lower surface of the substrate.

However, the heat conductivity of the material is rather low. Therefore, the gap between the LSI and the cap is narrowed by a protruding portion of the cap protruding toward the LSI. When the heat conductivity of the material is around 1.7 W/mK, the width of the gap is preferably within a range of approximately 100µm to 200µm.

However, narrowing the gap between the cap and the LSI increases the risk that the cap contacts the conductor to cause a short-circuit. To prevent the short-circuit, an insulator is provided between the cap and the conductor. In the first embodiment, the insulator is preferably an insulating film provided on the TAB leads. In the second and third embodiments, the insulator is preferably an insulation coating provided over the lower surface or the cap.

The risk of a short-circuit also can be reduced in other ways. For example, in the fourth embodiment the width of the protruding portion is set such that it is narrower than the width between opposing pads of the LSI.

Other objects, features and advantages of the present invention will become more apparent when the following description is read in conjunction with the accompanying drawings, wherein:
Fig. 1 illustrates a heat conduction path in a pin-grid array according to a conventional system.
Fig. 2 is a sectional view of a pin-grid array according to the first embodiment of the present invention.
Fig. 3 is a plan view of the insulating film 4a and TAB leads 4.
Fig. 4 is a perspective view of the sealing cap 6 of the first embodiment.
Figs. 5 (a), (b) and (c) illustrate the assembly process of a pin-grid array of the first embodiment.
Fig. 6 illustrates the heat conducting path in a pin-grid array according to the first embodiment of the present invention.
Fig. 7 is a sectional view of a pin-grid array of the second embodiment of the present invention.
Fig. 8 is a perspective view of the sealing cap 6 of the second embodiment.
Fig. 9 is a sectional view of a pin-grid array of the third embodiment of the present invention.
Fig. 10 is a sectional view of a pin-grid array of the fourth embodiment of the present invention.
Fig. 11 shows the relationship between a width of the base of the cavity in the sealing cap 6 and the gap between pads of the LSI 3.
Fig. 12 shows the extended area 6' of the sealing cap 6.

In these drawings, the same reference numerals depict the same parts, respectively.

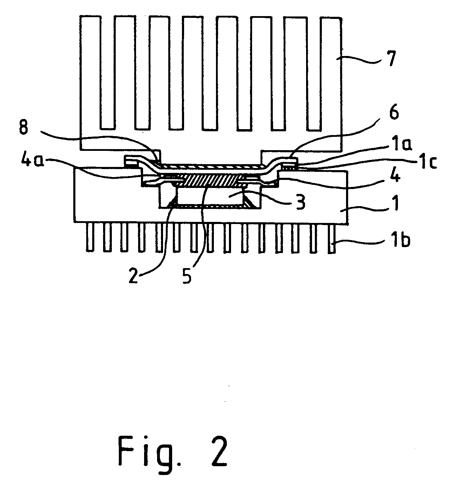

Referring to fig. 2, a pin-grid array of the first embodiment of the present invention comprises a substrate 1 preferably formed of alumina ceramic. The thermal conductivity of the substrate 1 is preferably about 17 W/mK.

The substrate 1 has a plurality of input/output pins 1b. The pins 1b are arranged in an array over substantially the entire lower surface of the substrate 1.

The substrate 1 has a cavity in its upper surface for receiving an LSI 3. The LSI 3 is coupled to the base of the cavity such as with an adhesive 2. High thermal conductivity materials such as epoxies including silver fillers, and in which the heat conductivity is about 1.5 W/mK, are preferably used as the adhesive 2. The LSI 3 is die-bonded or mounted with its circuit face up.

TAB leads 4 interconnect the LSI 3 and the substrate 1. TAB leads are preferably made of Cu plated with Sn or Au. The thickness of the TAB leads is preferably about 50µm. The inner leads of TAB leads 4 are bonded to opposing pads (unillustrated in fig. 2) of the LSI 3. The outer leads of the TAB leads 4 are bonded to electrical terminals of the substrate 1 in the cavity. Thus, the LSI 3 is electrically connected to the pins 1b via TAB leads 4 and conductors in the substrate 1. The height of the bonding portion of the LSI 3 is typically the same as the height of the opposing pads of the LSI 3 and preferably about 10µm.

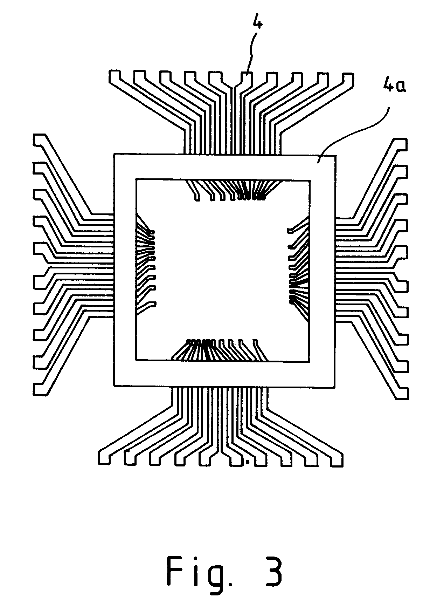

Referring to figs. 2 and 3, insulating film 4a is adhered to the upper surface of the TAB leads 4. The thickness of the insulating film 4a is preferably about 75µm. The insulating film 4a prevents a short circuit which happens when a sealing cap 6, as explained below, directly contacts the TAB leads 4. Polyimide films can be used as the insulating film 4a.

Referring back to fig. 2, the sealing cap 6 is attached to the substrate 1 and covers the cavity of the substrate 1. The sealing cap is preferably made of high heat-conductive metals such as Kovar having a heat conductivity of preferably about 16.4 W/mK. The sealing cap 6 is joined to a seal ring 1a by seam welding to provide an airtight sealing of the device. The seal ring 1a preferably comprises Kovar or other suitable material. The seal ring 1a is disposed on a relatively thick film 1c on the substrate 1. The preferred material of the thick film 1c is at least one of tungsten, nickel, gold and copper.

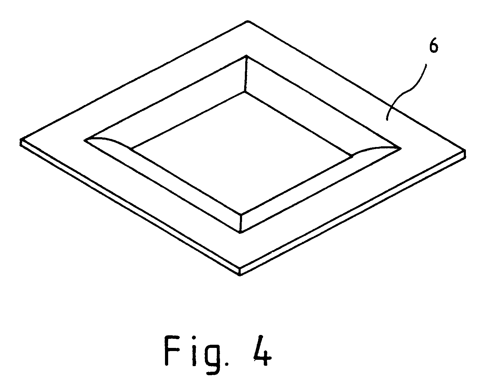

Referring to fig. 4, the center portion of the sealing cap 6 is bent toward the LSI 3 to form a bent structure. This bent structure protrudes toward LSI 3. The bent structure includes upturned ends and a depressed middle portion (e.g., a dented area or depression). The base (middle portion) of the bent structure is flat. The bent structure narrows the gap between the upper surface of the LSI 3 and the lower surface of the sealing cap 6. Specifically, the gap between them is about 150µm.

Referring to fig. 2, an electrically insulating thermally conductive material 5 is put into the gap between the LSI 3 and the sealing cap 6. A silicone compound containing fine particles of highly heat-conducting materials such as ALN or BN, or epoxy adhesive is desirable as the material 5. The heat conductivity of the material 5 is preferably about 1.7 W/mK, which is an order of magnitude smaller than that of the substrate 1. The material 5 is viscous so as not to flow.

The thickness of the material 5 is preferably within the 100 µm to 200 µm range when the aforementioned materials are used as the material 5. If the thickness exceeds 200 µm, the thermal resistance between the LSI 3 and the sealing cap 6 increases undesirable. If the heat conductivity of the material 5 is greater than 1.7 W/mK, the range of its permissible thickness can be increased.

A heat sink 7 is fitted to the sealing cap 6. The heat sink 7 is coupled to (e.g., such as by gluing) the upper surface of the sealing cap 6 by a thermally conductive adhesive 8 such as an epoxy.

An assembly process of the pin-grid array according to the present embodiment is described below.

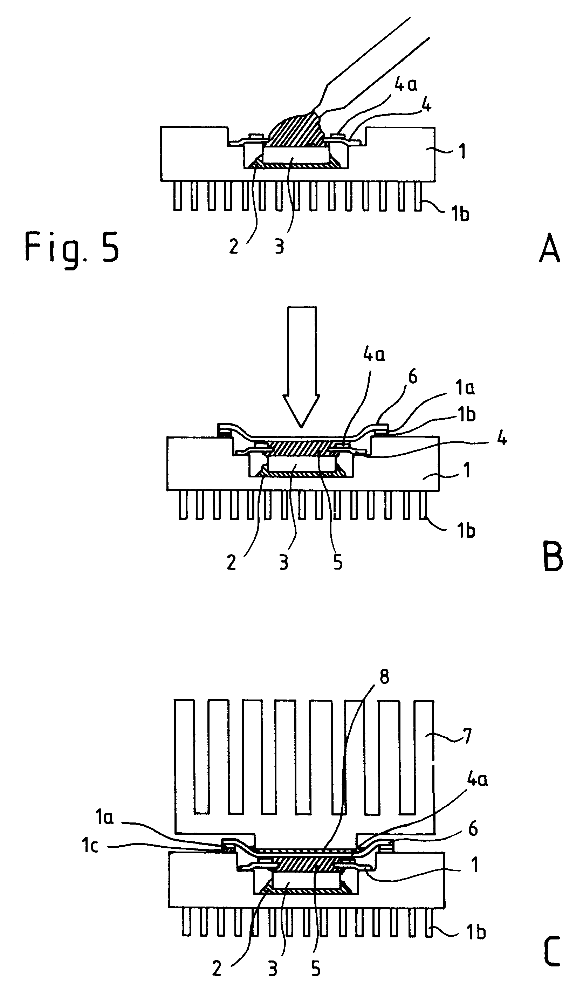

Referring to fig. 5(a), in the first step, the LSI 3 is fitted to the base of the cavity of the substrate 1. The TAB leads 4 are bonded to the LSI 3 and the substrate 1. The detailed bonding process and the structure of the TAB leads are described in Rao R. Tummala and Eugene J. Rymaszewski "Microelectronics Packaging Handbook" p.409-453, Van Nostrand Reinhold, 1989 and thus are not described herein. Then, the material 5 is put on the LSI 3.

Referring to fig. 5(b), in the second step, the sealing cap 6 is pressed toward the substrate 1 having a thick film thereon to squeeze the material to be 5 to 150µm in thickness. Then, the sealing cap 6 and the seal ring 1a disposed on the thick film on the substrate are joined by seam welding.

Referring to fig. 5(c), in the third step, the heat sink 7 is suitably attached to the upper surface of the sealing cap 6 by a thermally conductive adhesive 8.

The heat transfer in the pin-grid array according to the first embodiment is described below.

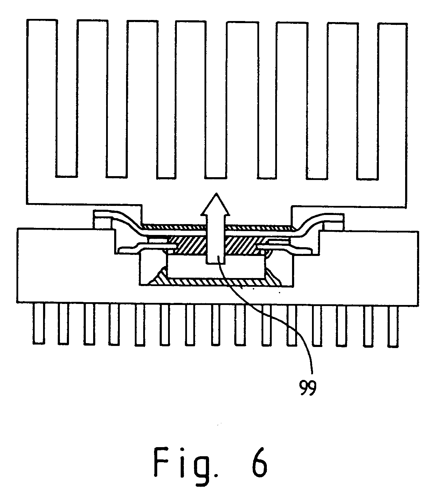

Referring to fig. 6, the material 5 conducts heat released by the circuit surface of the LSI to the sealing cap 6 and then to the heat sink 7 via the heat conductive adhesive 8 as shown by path 99.

The heat resistance along this heat conductive path 99 is sufficiently low because the gap between the LSI 3 and the sealing cap 6 is narrowed to 150µm by the bent structure of the sealing cap 6. Therefore, the heat sink 6 alone can simply remove the heat from the LSI 3 and it is unnecessary to provide another heat sink on the lower surface of the substrate 1.

As stated above, according to the first embodiment of the present invention, it is unnecessary to provide a cooling structure on the lower surface of the substrate over which pins are arranged. Removal of the cooling structure makes it possible for the pin-grid array to accommodate a plurality of pins across substantially the entire lower surface of the substrate 1.

Hereinbelow is described a second embodiment of the present invention.

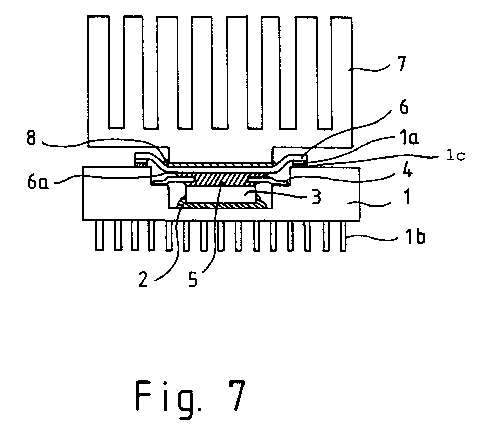

Referring to fig. 7, a feature of the second embodiment is an insulation coating 6a over the lower surface of the sealing cap instead of the insulating film 4a on the TAB leads 4 as in the first embodiment. With respect to other structure and functions, the second embodiment is the same as the first embodiment.

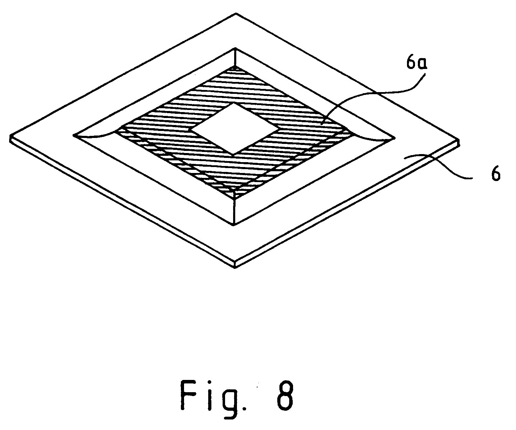

Referring to fig. 8, the insulation coating 6a is provided over an area where the sealing cap may directly contact the TAB leads 4 to produce a short-circuit. Specifically, the insulation coating 6a is provided over the lower surface of the bent structure (e.g., the depressed portion) of the sealing cap 6 except for the central area thereof. A thickness of the insulation coating 6a is almost the same as that of the insulating films 6a. Any kind of insulating resin can be used as the insulation coating 6a. The insulation coating 6a prevents short-circuiting should the sealing cap 6 directly contact the TAB leads 4.

Hereinbelow is described a third embodiment of the present invention.

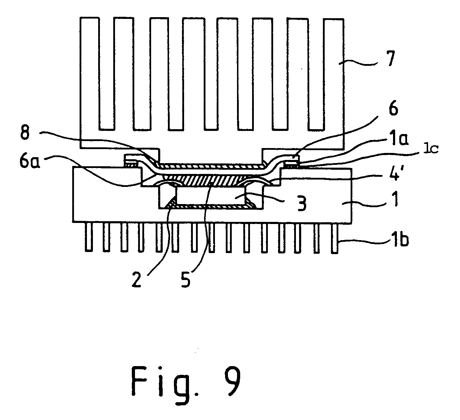

Referring to fig. 9, a feature of the third embodiment resides in connecting the LSI 3 and the substrate 1 by gold wires 4' instead of the TAB leads 4 as in the second embodiment. With respect to the other structure and the functions, the third embodiment is the same as the second embodiment.

The third embodiment, similarly to the second embodiment, has a sealing cap 6 provided with the insulation coating 6a because it is difficult to provide wires 4' with insulating films 6a.

Hereinbelow is described a fourth embodiment of the present invention.

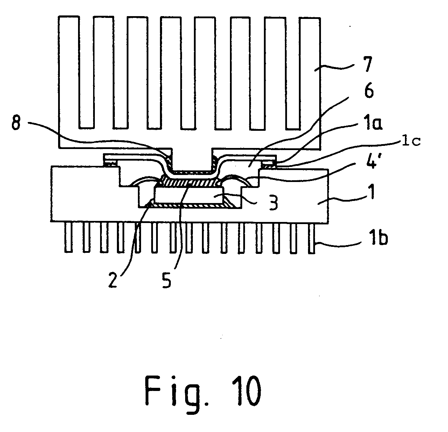

Referring to fig. 10, a feature of the fourth embodiment as compared with the third embodiment resides in narrowing the width of the bent structure (e.g., the middle portion between the upturned end portions) of the sealing cap 6 and removing the insulation coating 6a from the sealing cap 6. With respect to the other structure and functions, the fourth embodiment is the same as the third embodiment.

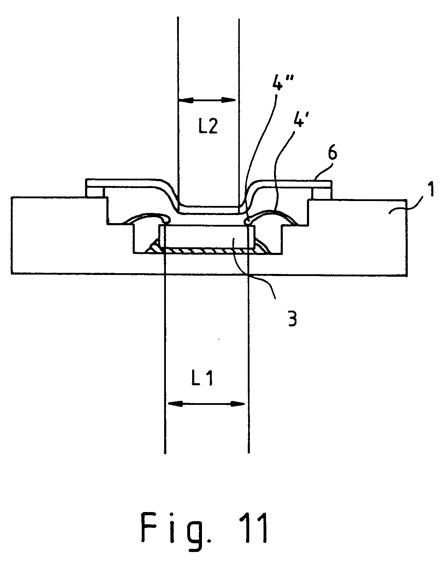

Referring to fig. 11, the width L2 of the base (middle portion) of the bent structure of the sealing cap 6 is narrower than width L1 of the space between opposing pads of LSI 3 which are connected to the wires 4'. This structure prevents the sealing cap 6 from contacting the wires 4'. Therefore, insulation coating 6a is unnecessary in this configuration and is removed. To further prevent short-circuiting the wires 4 are curved so as to retreat from the sealing cap 6.

It will be appreciated that many modifications may be made in the present invention.

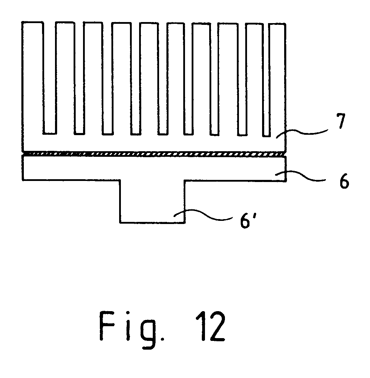

For example, as shown in fig. 12, the sealing cap 6 may have an extended area 6' such as an extension (e.g., a bump or protrusion) protruding toward the LSI 3 on its lower surface instead of the depressed middle portion of the bent structure. According to this structure, the heat sink 7 is easily and readily fitted to the sealing cap 6 because the upper surface of the sealing cap 6 is flat.

Further, cooling structures other than the heat sink 7 can be attached to the sealing cap 6. Applicable cooling structures include liquid cooling structures as well as air cooling structures or the like. Examples of cooling structures applicable to the present invention include those described in Rao R. Tummala and Eugene J. Rymaszewski "Microelectronics Packaging Handbook" p.209-219, Van Nostrand Reinhold, 1989. Moreover, IBM Thermal Conduction Module, NEC SX Liquid cooling Module, and Fujitu Liquid-Cooled Bellows Cooling Scheme shown in figures 4-21, 4-25 and 4-26, respectively, of the above-mentioned reference can easily be applied to the present invention.

The invention may be embodied in other specific forms without departing from the spirit or essential characteristics thereof. The present embodiment is therefore to be considered in all respects as illustrative and not restrictive, the scope of the invention being indicated by the appended claims rather than by the foregoing description and all changes which come within the meaning and range of equivalency of the claims are therefore intended to be embraced therein.

## Claims

1. A pin-grid array comprising:
a substrate having a plurality of electrical terminals on a first surface thereof;
an electrical device placed on a second surface of said substrate;
a conductor connecting said substrate and said electrical device, said electrical device being connected to said electrical terminals of said substrate via said conductor;
a cap for covering said electrical device; and
a heat conductive structure interposed between said electrical device and said cap.

2. A pin-grid array according to claim 1, further comprising a cooling structure provided on said cap.

3. A pin-grid array according to claim 2, wherein said cooling structure comprises a heat sink.

4. A pin-grid array according to claim 1, 2 or 3, wherein said cap includes a protruding portion protruding toward said electrical device, said heat conductive structure being interposed between said protruding portion of said cap and said electrical device.

5. A pin-grid array according to claim 4, wherein said cap includes first and second end portions and a protruding portion coupled between said first and second end portions, said protruding portion of said cap comprising a flat structure being positioned closer to said electrical device than said first and second end portions of said cap.

6. A pin-grid array according to any one of claims 1 to 5, wherein said cap comprises an extended portion extending in a plane closer to said electrical device than other portions or said cap.

7. A pin-grid array according to claim 4, 5 or 6, wherein said electrical device includes opposing pads, wherein a distance between opposing ends or said protruding portion is less than a distance between said opposing pads of said electrical device.

8. A pin-grid array according to any one of claims 1 to 7, wherein a width of a gap between said electrical device and said cap is substantially within a range of 100µm to 200µm.

9. A pin-grid array according to any one of claims 1 to 8, further comprising an insulator positioned between said conductor and said cap.

10. A pin-grid array according to claim 9, wherein said insulator comprises an insulating film provided on said conductor.

11. A pin-grid array according to claim 9 or 10, wherein said insulator comprises an insulation coating provided over said cap.

12. A pin-grid array according to any one of claims 1 to 11, wherein said heat conductive structure comprises a viscous material.

13. A pin-grid array according to claim 12, wherein said heat conductive structure includes a silicone compound.

14. A pin-grid array according to claim 13, wherein said silicone compound contains a filler.

15. A pin-grid array according to claim 14, wherein said filler comprises at least one of ALN and BN.

16. A pin-grid array according to any one of claims 12 to 15, wherein said heat conductive structure includes an epoxy.

17. A pin-grid array according to any one of claims 1 to 16, wherein said conductor comprises a plurality of leads for receiving said insulator.

18. A pin-grid array according to claim 17, wherein said plurality of leads includes TAB leads.

19. A pin-grid array according to any one of claims 1 to 18, wherein said conductor comprises wires and wherein said electrical device comprises opposing pads, said wires being coupled to said opposing pads of said electrical device.

20. A pin-grid array according to claim 19, wherein said cap includes a protruding portion protruding toward said electrical device, a distance between opposing ends of said protruding portion being less than a distance between said opposing pads of said electrical device.

21. A pin-grid array according to any one of claims 1 to 20, wherein said electrical terminals of said substrate comprise pins.

22. A pin-grid array according to any one of claims 1 to 21, wherein a cavity is provided in a second surface of said substrate, said electrical device being positioned in said cavity of said substrate, said cap covering said cavity.

23. A pin-grid array comprising:
a substrate having a plurality of electrical terminals on a first surface thereof;
an electrical device placed on a second surface of said substrate;
a conductor connecting said substrate and said electrical device, said electrical device being connected to said electrical terminals of said substrate via said conductor;
a cap for covering said electrical device, said cap having first, second and third portions, said third portion extending between said first and second portions and being positioned closer to said electrical device than are said first and second portions; and
a heat conductive structure interposed between said electrical device and said third portion of said cap.
